# EUROPÄISCHE PATENTSCHRIFT

(11) **EP 1 693 905 B1**
(45) Veröffentlichungstag und Bekanntmachung des Hinweises auf die Patenterteilung: **20.08.2008**
(21) Anmeldenummer: 05003353.9
(22) Anmeldetag: 17.02.2005
(51) Int. Cl.: H01L 39/24, C23C 14/02, C23C 14/08, C23C 14/22, C30B 25/02, C30B 29/22

(54) **Verfahren zur Herstellung biaxial orientierter Dünnschichten**
Process of manufacturing biaxial oriented coatings
Procédé de préparation de revêtements à orientation biaxiale

(43) Veröffentlichungstag der Anmeldung: 23.08.2006
(73) Patentinhaber: European High Temperature Superconductors GmbH & Co. KG, 63450 Hanau (DE)
(72) Erfinder: Usoskin, Alexander Dr., 37075 Göttingen (DE); Kirchhoff, Lutz, 37197 Hattorf (DE)
(74) Vertreter: Rehberg Hüppe + Partner

(56) Entgegenhaltungen:
- US-A1- 2001 051 231
- US-A1- 2002 073 918
- US-A1- 2005 011 747

## Beschreibung

Die Erfindung betrifft ein Verfahren zur Herstellung von Dünnschichten, die eine biaxiale Kristallorientierung aufweisen, mit den Schritten des Oberbegriffs des Patentanspruchs 1.

Die Ausbildung von Dünnschichten mit biaxialer Kristallorientierung hat besondere Bedeutung bei der Herstellung von supraleitenden Bändern, bei denen es bekannt ist, auf einem nicht einkristallinen Substrat, beispielsweise einem Band auf rostfreiem Stahl, zunächst eine Pufferschicht mit biaxialer Kristallorientierung anzuordnen, bevor hierauf das eigentlich supraleitende Material, ebenfalls mit biaxialer Kristallorientierung, aufgebracht wird. Die biaxiale Kristallorientierung der Pufferschicht prägt insbesondere einer epitaktisch aufwachsenden Schicht aus dem supraleitenden Material die gewünschte biaxiale Orientierung auf. Für eine supraleitende Schicht aus YBCO (Yttriumbariumkupferoxid) ist die Verwendung einer Pufferschicht aus YSZ (mit Yttriumoxid stabilisiertem Zirkonoxid) bekannt. Der Fachmann weiß aber auch von anderen Materialien zur Ausbildung von Pufferschichten für das genannte und andere supraleitende Materialien.

Die vorliegende Erfindung befasst sich ausschließlich mit der Ausbildung von Dünnschichten, die eine biaxiale Kristallorientierung aufweisen, und die beispielsweise als Pufferschichten bei supraleitenden Bändern Verwendung finden können. Andere Aspekte der Herstellung von supraleitenden Bändern finden hier keine Berücksichtigung. Ebenso wenig ist die vorliegende Erfindung auf eine Anwendung im Rahmen der Herstellung von supraleitenden Bändern beschränkt.

Bei der Herstellung von Dünnschichten, die eine biaxiale Kristallorientierung aufweisen, konzentriert sich die vorliegende Erfindung auf solche Techniken, bei denen ein Einfluss eines energetisierten Strahls, der unter einem bestimmten Winkel zu dem Substrat ausgerichtet wird, auf die Kristallorientierung einer Dünnschicht ausgenutzt wird, die auf dem Substrat abgelagert wird.

### STAND DER TECHNIK

Ein Verfahren zur Herstellung von Dünnschichten, die eine biaxiale Kristallorientierung aufweisen, mit den Schritten: Ablagern von Atomen in einer der gewünschten Dünnschicht entsprechenden Zusammensetzung auf einem Substrat und - gleichzeitig mit dem Schritt des Ablagerns von Atomen - Beaufschlagen der abgelagerten Atome mit einem energetisierten Strahl, der unter einem Winkel aus einem vorgegebenen Winkelbereich zu dem Substrat ausgerichtet ist, ist aus der US 5,432,151 A bekannt. Dieses Verfahren wird auch als IBAD (Ion Beam Assisted Deposition) bezeichnet und wird in einer Vorrichtung durchführt, die eine Quelle für Atome in einer der gewünschten Dünnschicht entsprechenden Zusammensetzung und eine Quelle für einen energetisierten Strahl aufweist, wobei das Substrat so in einem gemeinsamen Arbeitsbereich der beiden Quellen positioniert ist, dass zur selben Zeit Atome auf dem Substrat abgelagert und die sich auf dem Substrat ablagernden Atome mit einem energetisierten Strahl beaufschlagt werden können. Der energetisierte Strahl ist ein Teilchenstrahl aus beschleunigten Argonionen, der unter einem Winkel zwischen von etwa 20 bis etwa 70° zu dem Substrat ausgerichtet ist und der zu einem teilweisen wieder Abtragen der auf dem Substrat abgelagerten Atome führt. Dabei werden vornehmlich solche Atome entfernt, die nicht unter der gewünschten biaxialen Kristallorientierung auf dem Substrat abgelagert wurden. Dies führt dazu, dass mit aufwachsender Schichtdicke der jeweiligen Dünnschicht die Bereiche mit Texturen, die nicht der gewünschten Kristallorientierung entsprechen, zugunsten der Bereiche mit der gewünschten Kristallorientierung zurückgedrängt werden.

Dadurch, dass das Substrat bei IBAD gleichzeitig in den Arbeitsbereichen beider Quellen für Atome und für einen energetisierten Strahl anzuordnen ist, sind die Platzverhältnisse in der bekannten Vorrichtung beengt, insbesondere dann, wenn die Quellen vergleichsweise dicht an das Substrat herangebracht werden. Die mit dem bekannten Verfahren hergestellten Dünnschichten weisen eine markante Abhängigkeit ihrer gewünschten biaxialen Kristallorientierung von der Schichtdicke der ausgebildeten Dünnschicht auf. Bei einer Röntgenanalyse der Textur einer mit IBAD hergestellten Dünnschicht folgt die Halbwertsbreite der Peaks (phi-Scan) einer abfallenden Exponentialfunktion. Halbwertsbreiten von 25° werden erst ab einer Mindestschichtdicke von 500 nm erreicht, und noch kleinere Halbwertsbreiten erfordern noch erheblich größere Schichtdicken der Dünnschicht. Da das Dickenwachstum einer mit IBAD abgelagerten Dünnschicht nur klein ist, wird hierdurch die Produktivität des bekannten Verfahrens bei der Herstellung von Dünnschichten mit einer gewünschten ausgeprägten biaxialen Kristallorientierung eng begrenzt.

Ein Verfahren zur Herstellung von Dünnschichten, die eine biaxiale Kristallorientierung aufweisen, ist auch aus der US 2002/0073918 A1 bekannt. Im Gegensatz zu dem als IBAD bekannten Verfahren erfolgt eine räumliche und zeitliche Trennung des Schritts des Ablagerns von Atomen auf dem Substrat und des Schritts des Beaufschlagens der abgelagerten Atome mit einem energetisierten Strahl. Gemäß der US 2002/0073918 A1 werden also zunächst die Atome für die gewünschte Dünnschicht auf dem Substrat abgelagert und anschließend wird diesen abgelagerten Atomen die gewünschte biaxiale Kristallorientierung mit einem energetisierten Strahl aufgeprägt. Hierzu wird ebenfalls ein Partikelstrahl aus beschleunigten Argonionen unter einem Winkel von etwa 55° zu dem Substrat auf die Dünnschicht aus den abgelagerten Atomen gerichtet. Hierdurch wird der Dünnschicht an der Oberfläche eine Textur aufgeprägt, die der gewünschten biaxialen Kristallorientierung entspricht. Allerdings ist die Reichweite der Argonionen in der Tiefe der Dünnschicht auf wenige Nanometer beschränkt. So kann die gewünschte biaxiale Orientierung der Dünnschicht mit dem energetisierten Strahl nur über eine geringe Tiefe aufgeprägt werden, die allenfalls durch anschließendes anlassen der Dünnschicht und damit einhergehendes Kristallwachstum in die Tiefe der Dünnschicht vergrößert werden kann. Aber auch dann wird mit dem bekannten Verfahren nur eine ansatzweise biaxiale Textur erzielt, die einer Halbwertsbreite bei der Röntgenanalyse von nicht deutlich mehr als 25° (phi-Scan) entspricht. Dieses vergleichsweise schlechte Ergebnis bei der gewünschten biaxialen Kristallorientierung wird nicht dadurch wett gemacht, dass durch die zeitliche Trennung der Schritte des Ablagerns und des Beaufschlagens der abgelagerten Atome mit einem energetisierten Strahl auch eine räumliche Trennung dieser Schritte möglich ist, so dass sich die Quellen für Atome und für einen energetisierten Strahl bei der notwendigen Überlappung ihrer Arbeitsbereiche nicht gegenseitig behindern.

Ein Verfahren zur Herstellung von Dünnschichten, die eine biaxiale Kristallorientierung aufweisen, mit den Merkmalen des Oberbegriffs des Patentanspruchs 1 ist aus der US 2005/0011747 A1 bekannt. Hier wird ein bandförmiges Substrat in einer Spirale um einen Kühlblock geführt. Auf einer Seite des Kühlblocks wird eine beispielsweise amorphe Dünnschicht abgelagert, die auf der anderen Seite des Kühlblocks durch Beschuss mit lonen in eine bevorzugte Textur überführt wird.

### AUFGABE DER ERFINDUNG

Der Erfindung liegt die Aufgabe zugrunde, ein Verfahren zur Herstellung von Dünnschichten, die eine biaxiale Kristallorientierung aufweisen, mit den Schritten des Oberbegriffs des Patentanspruchs 1 aufzuzeigen, das es ermöglicht, Dünnschichten mit besserer biaxialer Kristallorientierung herzustellen, als sie bei gleich dicken mit IBAD hergestellten Dünnschichten erreicht wird. Weiterhin sollen die räumlichen Beschränkungen, die bei IBAD durch die zur Deckung zu bringenden Arbeitsbereiche der Quellen für Atome und für einen energetisierten Laserstrahl bestehen, dennoch beseitigt werden.

### LÖSUNG

Die Aufgabe der Erfindung wird durch ein Verfahren zur Herstellung von Dünnschichten mit den Schritten des Patentanspruchs 1 gelöst. Vorteilhafte Ausführungsformen des neuen Verfahrens sind in den Unteransprüchen 2 bis 3 beschrieben.

### BESCHREIBUNG DER ERFINDUNG

Bei dem neuen Verfahren werden die Schritte des Ablagerns von Atomen auf dem Substrat und dem Beaufschlagens der abgelagerten Atome mit einem energetisierten Strahl sowohl zeitlich getrennt als auch mehrfach alternierend wiederholt. D. h., die Atome für die gewünschte Dünnschicht werden nicht in einem einzigen Schritt des Ablagerns auf dem Substrat abgelagert, sondern es wird zunächst nur ein kleiner Teil der Atome auf dem Substrat abgelagert. Dieser Teil der Atome wird dann mit einem energetisierten Strahl beaufschlagt. Erst anschließend werden weitere Atome auf das Substrat bzw. die schon abgelagerten Atome abgelagert. Dann wird das Beaufschlagen mit einem energetisierten Strahl wiederholt. Die gesamte Dünnschicht wird in derartigen Schritten aufgebaut, die in Bezug auf den damit jeweils auf das Substrat aufgebrachten Anteil der gesamten Dünnschicht nur klein sind. Typischerweise wird die gesamte Dünnschicht, deren Dicke in aller Regel immer größer als 100 nm ist und typischerweise einige 100 nm beträgt, in mindestens zehn aufeinander folgenden Schritten des Ablagerns von Atomen auf dem Substrat und entsprechenden zehn Schritten des Beaufschlagens der abgelagerten Atome mit einem energetisierten Strahl ausgebildet. Die mittlere Dicke, um die die Dünnschicht pro Schritt des Ablagerns mit nachgeschaltetem Schritt des Beaufschlagens der abgelagerten Atome mit einem energetisierten Strahl anwächst, hängt von den konkreten Parametern ab, mit denen das Verfahren durchgeführt wird. Typische Werte liegen bei wenigen Nanometern bis 40 nm bei der Ausbildung der jeweiligen Dünnschicht aus dielektrischen Materialien mit hoher Schmelztemperatur (> 1300 °C) und bei bis zu 20 nm und mehr bei der Ausbildung der Dünnschicht aus elektrisch leitfähigen Materialien, wie z. B. Metallen mit einer Schmelztemperatur < 1200 °C. Bei Metallen kann entsprechend die Dünnschicht in zwanzig Schritten des Ablagerns und anschließenden Beaufschlagens auf eine Dicke von 400 nm vergrößert werden. Bereits über eine solche Dicke weist eine nach dem neuen Verfahren hergestellte Dünnschicht häufig schon eine ausgeprägte biaxiale Orientierung auf, die sich durch eine Halbwertsbreite der Peaks bei einer Röntgenanalyse von etwa 20° (phi-Scan) oder sogar schon weniger widerspiegelt. Es wird also schneller eine geringe Halbwertsbreite der Peaks in der Röntgenanalyse erreicht als bei IBAD. Dies mag darauf zurückzuführen sein, dass bei dem neuen Verfahren die Atome, die nicht in der gewünschten biaxialen Kristallorientierung abgelagert wurden, in dem nachfolgenden Schritt des Beaufschlagens mit einem energetisierten Strahl im Wesentlichen vollständig wieder von dem Substrat entfernt werden und damit im Wesentlichen nur solche Atome auf dem Substrat verbleiben, die die gewünschte biaxiale Kristallorientierung aufweisen, während bei IBAD eine nicht unerhebliche statistische Wahrscheinlichkeit gegeben ist, dass auch Atome mit einer anderen als der gewünschten biaxialen Kristallorientierung auf dem Substrat zurückbleiben und hierauf weitere Atome epitaktisch aufwachsen. Entsprechende fehlorientierte Bereiche der Dünnschicht können dann beim weiteren Aufwachsen der Dünnschicht nur zurückgedrängt aber nicht mehr ganz beseitigt werden.

Die zeitliche Trennung der einzelnen Schritte des Ablagerns der Atome und des Beaufschlagens der abgelagerten Atome mit dem energetisierten Strahl muss bei dem neuen Verfahren nicht soweit gehen, dass es keinerlei zeitliche Überschneidung zwischen ihnen gibt. Es ist ausreichend, wenn die Schritte im Wesentlichen keine zeitliche Überlappung aufweisen, obwohl es bevorzugt ist, keine Überlappung zu haben bzw. jede vorhandene Überlappung möglichst klein zu halten.

Bei dem neuen Verfahren ist es weiter bevorzugt, wenn in jedem Schritt des Ablagerns von Atomen auf dem Substrat nicht zusammenhängende Cluster von Atomen auf dem Substrat bzw. dem bereits zuvor mit einem energetisierten Strahl beaufschlagten Atomen abgelagert werden. In jedem Schritt des Ablagerns werden also keine geschlossenen Lagen von Atomen abgelagert, sonder nicht zusammenhängende einzelne Gruppen. Wenn diese nicht zusammenhängenden Cluster von Atomen anschließend mit einem energetisierten Strahl beaufschlagt werden, werden sie mit besonders hoher Wahrscheinlichkeit wieder vollständig entfernt. So wird in der Dünnschicht sehr schnell eine hohe Konzentration an Bereichen der Textur mit der gewünschten biaxialen Kristallorientierung erreicht.

Um das neue Verfahren in effizienter Weise umzusetzen, d. h. die Schritte des Ablagerns von Atomen und des Beaufschlagens der abgelagerten Atome mit einem energetisierten Strahl möglichst rasch mehrfach hintereinander durchzuführen, kann das Substrat auf einer Kreis- oder Spiralbahn kontinuierlich umlaufend mehrfach wiederholt durch getrennte räumliche Bereiche geführt werden, in denen die Schritte des Ablagerns von Atomen auf dem Substrat einerseits und des Beaufschlagens der abgelagerten Atome mit einem energetisierten Strahl andererseits erfolgen. Das Substrat kommt also auf seiner Kreisbahn aufeinander folgend immer wieder in einen räumlichen Bereich, in dem Atome auf ihm abgelagert werden, und in einen räumlichen Bereich, in dem die abgelagerten Atome mit einem energetisierten Strahl beaufschlagt werden. Wenn sich das Substrat dabei auf einer Spiral- statt einer Kreisbahn befindet, kann das Substrat kontinuierlich gefördert werden, während das neue Verfahren in einer Vielzahl von Schritten ausgeführt wird.

Wenn das Substrat auf einer Kreis- oder Spiralbahn geführt wird, ist besonders bevorzugt, wenn das Substrat in jedem Bereich, in dem ein Schritte des Beaufschlagens der abgelagerten Atome mit einem energetisierten Strahl erfolgt, in einer Ebene ausgerichtet ist. Hierdurch werden besonders günstige Verhältnisse für das Erreichen der gewünschten biaxialen Kristallorientierung mit Hilfe des energetisierten Strahls geschaffen. Bei einem gekrümmten Verlauf des Substrats in diesem Bereich herrschen weit weniger konstante und damit weit weniger günstige Winkelverhältnisse. Auch in jedem Bereich, in dem ein Schritt des Ablagerns von Atomen auf dem Substrat erfolgt, ist es günstig, wenn das Substrat in einer Ebene ausgerichtet ist.

Auch wenn dies normalerweise der Fall sein wird, so ist es bei dem neuen Verfahren keinesfalls erforderlich, dass in den aufeinander folgenden Schritten des Ablagerns von Atomen immer genau dieselben Atome in immer genau derselben Zusammensetzung auf dem Substrat bzw. auf den bereits zuvor abgelagerten Atomen abgelagert werden. So ist es auch denkbar, die Zusammensetzung der abgelagerten Atome über die Dicke der hergestellten Dünnschicht zu variieren.

Ebenso muss der energetisierte Strahl in jedem Schritt des Beaufschlagens der abgelagerten Atome nicht immer identisch ausgebildet und ausgerichtet sein. Vielmehr kann der Strahl bezüglich seiner Art, seiner Zusammensetzung, seiner Energie, seiner Leistung und/oder des Winkels seiner Ausrichtung zu dem Substrat zwischen den einzelnen Schritten variiert werden. Auch hier gilt aber, dass der Strahl normalerweise über die einzelnen Schritte des Beaufschlagens der abgelagerten Atome hinweg nicht variiert wird.

In Bezug auf die Art des Strahls kann es sich um einen Strahl aus beschleunigten Edelgasionen handeln, wobei Argonionen gut geeignet sind. Die Ladung der beschleunigten Edelgasionen kann durch zusätzliche Elektronen neutralisiert werden, wie dies grundsätzlich bekannt ist. Bei dem energetisierten Strahl kann es sich aber grundsätzlich auch um einen Strahl aus leichterer Teilchen, wie beispielsweise Elektronen, oder einen elektromagnetischen Strahl ausreichender Energie handeln. Der Winkel unter dem der energetisierte Strahl bei der Erfindung zu dem Substrat ausgerichtet wird, wird in der Regel nicht ganz konstant sein, sondern einem wenige Grad breiten Winkelbereich entstammen. Dieser Winkelbereich kann bei 55° liegt. Die möglichen Extremwerte des Winkels liegen bei 20° bzw. 70°.

Eine Vorrichtung für die Herstellung von Dünnschichten, mit der das neue Verfahren ausführbar ist, weist einem Antrieb für das Substrat auf, um das Substrat mehrfach wiederholt alternierend vor der Quelle für Atome und vor der Quelle für einen energetisierten Strahl zu positionieren. Der Antrieb kann das Substrat in einander entgegen gesetzten Richtungen hin und her bewegen. Bevorzugt ist es aber, wenn der Antrieb das Substrat kontinuierlich auf einer Kreis- oder Spiralbahn bewegt.

Besonders bevorzugt ist es, wenn der Antrieb ein lang gestrecktes Band als Substrat auf einer Spiralbahn mit mehreren Gängen führt, wobei die Quelle für Atome und die Quelle für einen energetisierten Strahl das Substrat jeweils über mehrere, insbesondere alle Gänge der Spiralbahn erfassen. So kann das lang gestreckte Band über einen einmaligen Durchlauf durch die neue Vorrichtung mit einer vollständigen Dünnschicht mit biaxialer Kristallorientierung versehen werden.

Die Quelle für Atome und die Quelle für einen energetisierten Strahl können in unterschiedlichen Bereichen der Kreis- oder Spiralbahn von radial außen auf die Kreis- oder Spiralbahn gerichtet sein.

Es ist für die neue Vorrichtung jedoch nicht entscheidend, dass die Bereiche, in denen die verschiedenen Quellen für Atome und einen energetisierten Strahl auf das Substrat einwirken, keinerlei Überlappung aufweisen. Eine unwesentliche räumliche Überschneidung dieser Bereiche hat auf die gewünschte Funktion der neuen Vorrichtung vielmehr in der Regel auch nur einen unwesentlichen Einfluss.

Um das Gesamtvolumen an biaxial orientierter Dünnschicht, das innerhalb der Vorrichtung in bestimmter Zeit erzeugt werden kann, zu erhöhen, können mehrere Quellen für Atome und mehrere Quellen für einen energetisierten Strahl jeweils paarweise hintereinander längs der Bahn angeordnet sein, auf der das Substrat von dem Antrieb bewegt wird. Bei den mehreren Quellen für Atome und den mehreren Quellen für einen energetisierten Strahl kann es sich jeweils um identische Quellen aber auch um unterschiedliche Quellen handeln. Identische Quellen werden der Regelfall sein; es mag aber auch Fälle geben, in denen mit unterschiedlichen Quellen Dünnschichten von besonderer Qualität erzeugt werden können.

Vorteilhafte Weiterbildungen der Erfindung ergeben sich aus den abhängigen Patentansprüchen und der gesamten Beschreibung. Weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche abweichend von den gewählten Rückbeziehungen ist ebenfalls möglich und wird hiermit angeregt. Dies betrifft auch solche Merkmale, die in separaten Zeichnungsfiguren dargestellt sind oder bei deren Beschreibung genannt werden. Diese Merkmale können auch mit Merkmalen unterschiedlicher Patentansprüche kombiniert werden.

### KURZBESCHREIBUNG DER FIGUREN

Im Folgenden wird die Erfindung anhand in den Figuren dargestellter bevorzugter Ausführungsbeispiele weiter erläutert und beschrieben.
- Fig. 1: zeigt eine Ansicht von oben auf wesentliche Bestandteile einer Vorrichtung für die Herstellung von Dünnschichten in einer ersten Ausführungsform.
- Fig. 2: zeigt einen Antrieb für ein bandförmiges Substrat der Vorrichtung gemäß Fig. 1 in einer perspektivischen Seitenansicht.
- **Fig. 3**: zeigt eine Ansicht von oben auf wesentliche Bestandteile einer zweiten Ausführungsform der Vorrichtung für die Herstellung von Dünnschichten,
- Fig. 4: zeigt die Bestandteile der Vorrichtung gemäß Fig. 3 in einer perspektivischen Seitenansicht.
- Fig. 5: zeigt eine perspektivische Seitenansicht wesentlicher Bestandteile einer dritten Ausführungsform der Vorrichtung für die Herstellung von Dünnschichten.
- Fig. 6: zeigt eine perspektivische Seitenansicht einer gegenüber Fig. 5 um weitere Quellen für Atome und Quellen für einen energetisierten Strahl ergänzten Ausführungsform der Vorrichtung für die Herstellung Dünnschichten.
- Fig. 7: ist ein Blockdiagramm zur Hintereinanderschaltung mehrerer Vorrichtungen gemäß Figur 5 oder Figur 6; und
- Fig. 8: zeigt einen Querschnitt durch ein mit einer der Vorrichtungen gemäß den Fig. 1 bis 6 mit einer Dünnschicht beschichtetes bandförmiges Substrat.

### FIGURENBESCHREIBUNG

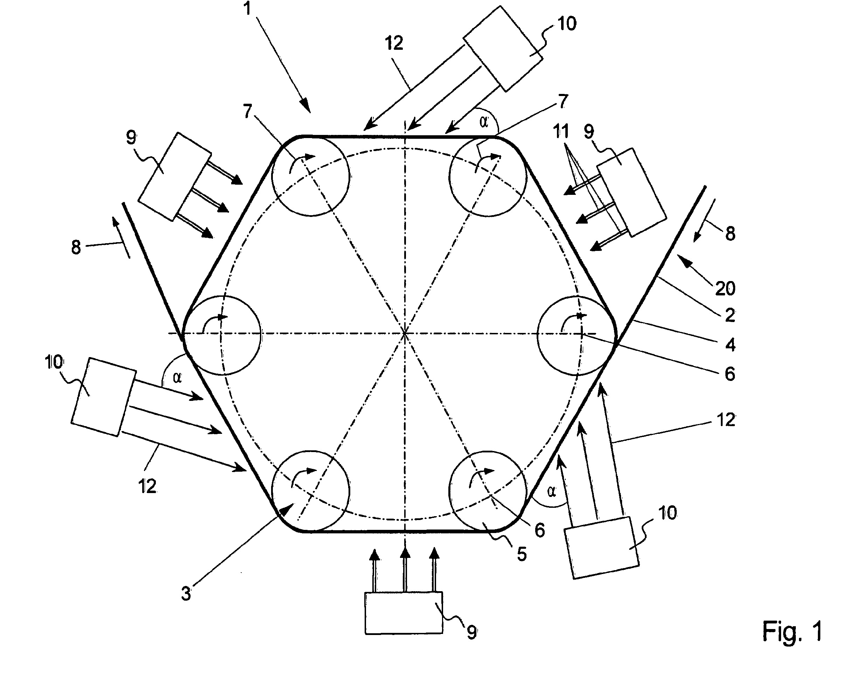

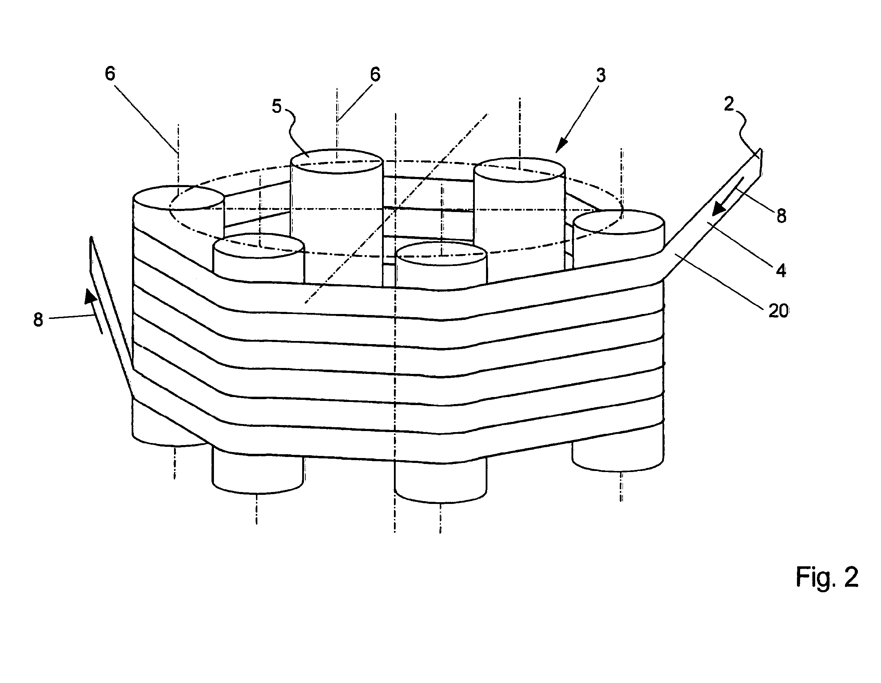

**Fig. 1** zeigt eine Vorrichtung 1 für die Herstellung einer Dünnschicht auf einem Substrat 2. Die Vorrichtung 1 weist einen Antrieb 3 für das Substrat 2 auf, das hier die Form eines lang gestreckten Bands 4 hat. Der Antrieb 3 für das Substrat 2 in Form des Bands 4 ist in **Fig. 2** separat dargestellt und besteht aus sechs drehbar gelagerten Walzen 5, deren Drehachsen 6 parallel zueinander verlaufen. Die Walzen 5 werden um ihre Drehachsen 6 gleichsinnig angetrieben, was in Fig. 1 durch Drehpfeile 7 angedeutet ist. Das Band 4 ist auf einer Spiralbahn um die Walzen 5 gewickelt, was am besten aus Fig. 2 hervorgeht. Durch die Drehbewegung der Walzen 5 wird das Band 4 in Richtung von Pfeilen 8 auf die Walzen 5 gezogen, die Spiralbahn entlang geführt und wieder von den Walzen 5 abgeführt. Das Band 4 ist dabei soweit gespannt, dass es jeweils zwischen zwei benachbarten Walzen 5 in einer Ebene verläuft, wobei das Band 4 in den einzelnen Gängen der Spiralbahn zwischen denselben Walzen 13 jeweils in denselben Ebenen verläuft. Diesen ebenen Bereichen des Bands 4 gegenüber sind abwechselnd Quellen 9 für Atome und Quellen 10 für einen energetisierten Strahl angeordnet. Die Quellen 9 geben Atome, die hier durch Pfeile 11 angedeutet sind, in einer Zusammensetzung ab, die der Zusammensetzung der Dünnschicht entspricht, die auf dem Substrat 2 ausgebildet werden soll. Die Quellen 9 sind hier so dargestellt, dass sie die Atome in normaler Richtung zu der Ebene des Substrats 42 abgeben. Dies kann der Fall sein, ist jedoch nicht zwingend. Die Quellen 10 geben einen energetisierten Strahl 12 hingegen unter einem definierten Winkel α zu der Ebene ab, in der das Substrat 2 vor ihnen ausgerichtet ist. Der energetisierte Strahl 12 dient dazu, von den mit der in Bewegungsrichtung des Bands 4 jeweils stromauf liegenden Quelle 9 abgelagerten Atomen diejenigen wieder von dem Band 4 abzutragen, die nicht eine gewünschte biaxiale Kristallorientierung in Bezug auf die Haupterstreckungsrichtung und die Oberflächennormale des Bands 4 aufweisen. Dabei wird auf dem Band 4 bei seinem mehrfachen Umlauf um die Walzen 5 von jeder Quelle 9 jeweils eine solche Menge an Atomen abgelagert, die einzelnen, nicht zusammenhängenden Clustern von Atomen auf dem Band 4 entspricht. Von diesen Clustern werden von der in der Bewegungsrichtung des Bands 4 folgenden Quelle 10 mit dem jeweiligen energetisierten Strahl 12 die Cluster wieder entfernt, die nicht die gewünschte biaxiale Kristallorientierung aufweisen, während die anderen Cluster nicht oder zumindest nicht vollständig wieder entfernt werden. So wächst mit dem wiederholten Hindurchpassieren des Bands 4 unter den Quelle 9 und 10 eine Dünnschicht in definierter Zusammensetzung und mit biaxialer Kristallorientierung auf dem Band 4 auf. Die gesamte Vorrichtung gemäß Fig. 1 befindet sich in aller Regel in einer Vakuumapparatur, um die Beschichtung des Bands 4 mit der Dünnschicht unter einer definierten Atmosphäre von geringem absoluten Druck durchzuführen.

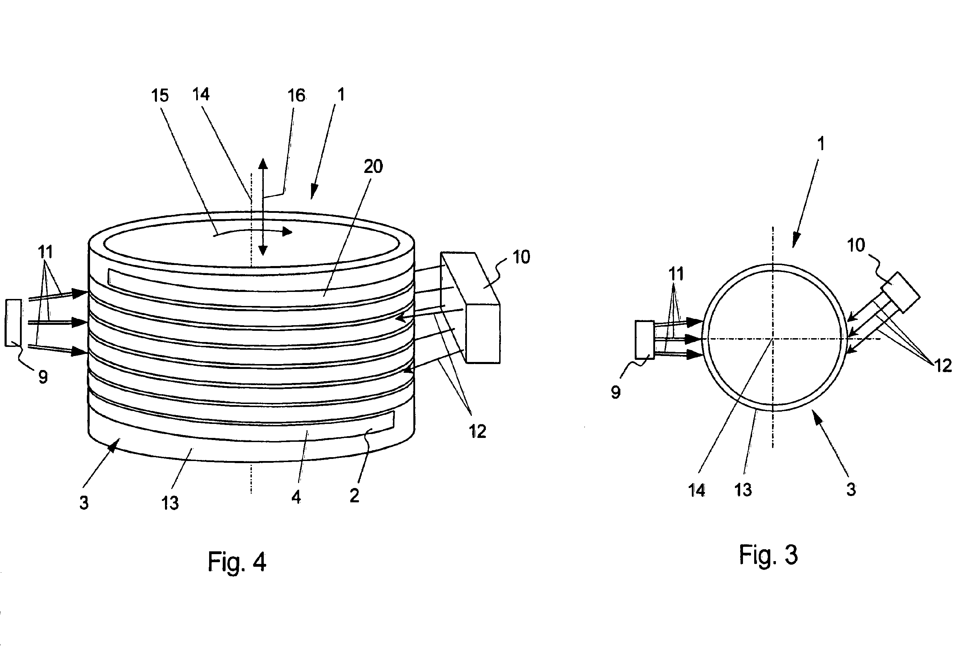

Die in den **Fig. 3 und 4** wiedergegebene Vorrichtung 1 weist als Antrieb für das Substrat 2, bei dem es sich hier ebenfalls um ein Band 4 handelt, eine Trommel 13 auf, die um eine Drehachse 14 in Richtung eines Drehpfeils 15 angetrieben gelagert ist. Weiterhin ist die Trommel 13 in Richtung der Drehachse 14 verschieblich, was durch einen Doppelpfeil 16 angedeutet ist. In zwei einander über die Drehachse 14 gegenüberliegenden Bereichen sind eine Quelle 9 für Atome und eine Quelle 10 für einen energetisierten Strahl 12 gegenüber dem Umfang der Trommel 13 angeordnet, auf den das Band 4 in einer Spiralbahn aufgewickelt ist. Durch Drehen der Trommel 13 um die Drehachse 14 und Verschieben der Trommel 13 längs der Drehachse 14 werden alle Bereiche des Bands 4 für gleich lange Zeiträume alternierend in den Einwirkungsbereich der Quellen 9 und 10 gebracht, so dass auf dem Band 4 über dessen gesamte Länge eine gleichmäßige Dünnschicht mit biaxialer Kristallorientierung aufwächst. Die Voraussetzungen für die Erzielung einer möglichst guten biaxialen Orientierung der auf dem Band 4 aufwachsenden Dünnschicht sind bei der Vorrichtung 1 gemäß den Fig. 3 und 4 nicht ganz so günstig wie bei der Vorrichtung 1 gemäß Fig. 1, weil der Winkel α, unter dem der energetisierte Strahl 12 von der Quelle 10 auf das Substrat 2 trifft, nur in der Mitte des Strahls 12 relativ genau dem vorgegebenen Wert entspricht, während er in den in Umfangsrichtung der Trommel 13 davor und dahinter liegenden Bereichen zunehmend stark nach unten bzw. oben von diesem Wert abweicht. Fig. 3 lässt deutlich werden, dass die neue Vorrichtung 1, mit der ein neues Verfahren zur Herstellung von Dünnschichten durchführbar ist, das sich von der bekannten IBAD-Technik wesentlich unterscheidet, grundsätzlich günstigere Verhältnisse in Bezug auf die Anordnung der Quellen 9 und 10 aufweist. Bei einer IBAD-Vorrichtung müssen sich die Einwirkungsbereiche der Quellen 9 und 10 überdecken. D. h., die Quellen 9 und 10 müssen in einem engen Winkelbereich oberhalb des Substrats 2 nebeneinander angeordnet werden. Diese Beschränkung ist bei der neuen Vorrichtung 1 nicht gegeben. Darüber hinaus ist es bei der neuen Vorrichtung 1 nicht erforderlich, dass die Einwirkungsbereiche der Quellen 9 und 10 auf das Substrat gleich groß sind. Es ist ausreichend, wenn auf irgendeine Weise sichergestellt ist, dass ein bestimmter Abschnitt des Bands 4 abwechselnd unter den Quellen 9 und 10 hindurchläuft und sich dabei für auf einander abgestimmte Zeiten in den Einwirkungsbereichen der Quellen 9 und 10 befindet, so dass die Quelle 10 mit dem energetisierten Strahl 12 jeweils möglichst gerade alle zuvor mit der Quelle 9 auf dem Band abgelagerten Atome entfernen kann, die nicht die gewünschte biaxiale Kristallorientierung aufweisen. Auch die Vorrichtung 1 gemäß den Fig. 3 und 4 wird sich in der Praxis immer innerhalb einer Vakuumvorrichtung befinden.

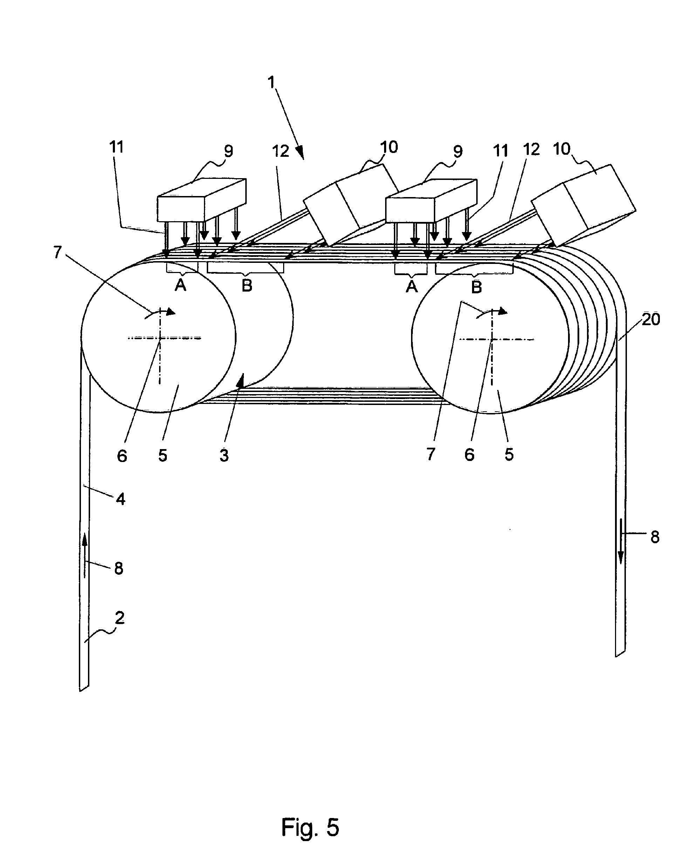

Bei der in **Fig. 5** skizzierten Vorrichtung 1 ist das erneut in Form eines Bands 4 vorliegende Substrat 2 um zwei den Antrieb 3 für das Substrat 2 ausbildende Walzen 5 mit parallel zueinander ausgerichteten Drehachsen 6 aufgewickelt. Dabei läuft das Band unter zwei Paaren von zwei Quellen 9 und 10 hindurch, deren Einwirkungsbereiche A und B an der Oberfläche 20 des Substrats 2 wechselweise aufeinander folgen.

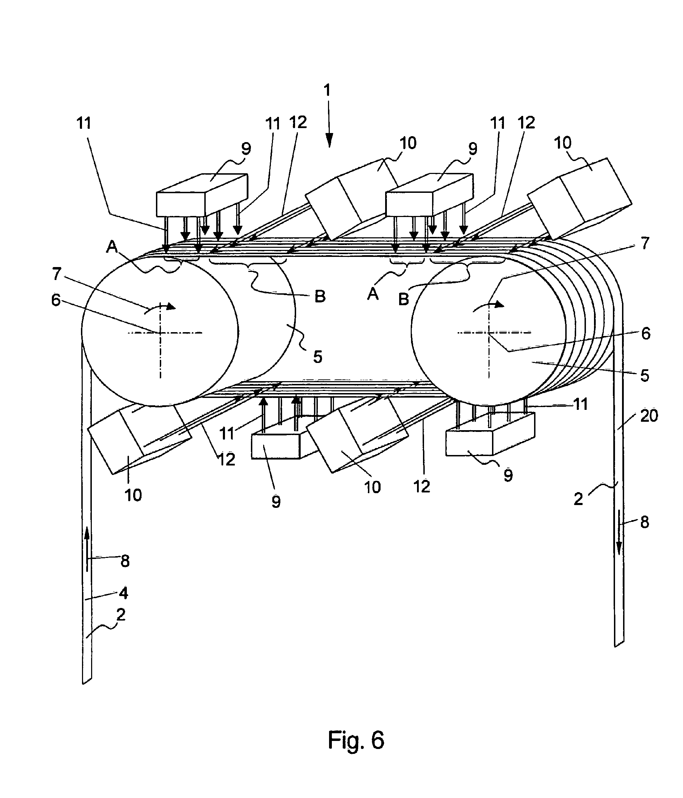

**Fig. 6** skizziert, wie bei der Anordnung gemäß Fig. 5 zwei zusätzliche Paare von Quellen 9 und 10 auf der gegenüberliegenden Seite der Walzen 5 gegenüber dem Band 4 angeordnet sind. Hierdurch wird bei gleicher Bewegungsgeschwindigkeit des Bands 4 in Richtung der Pfeile 8 und gleichen Betriebsbedingungen aller Quellen 9 und 10 die pro Zeiteinheit erzeugte Dicke der Dünnschicht verdoppelt.

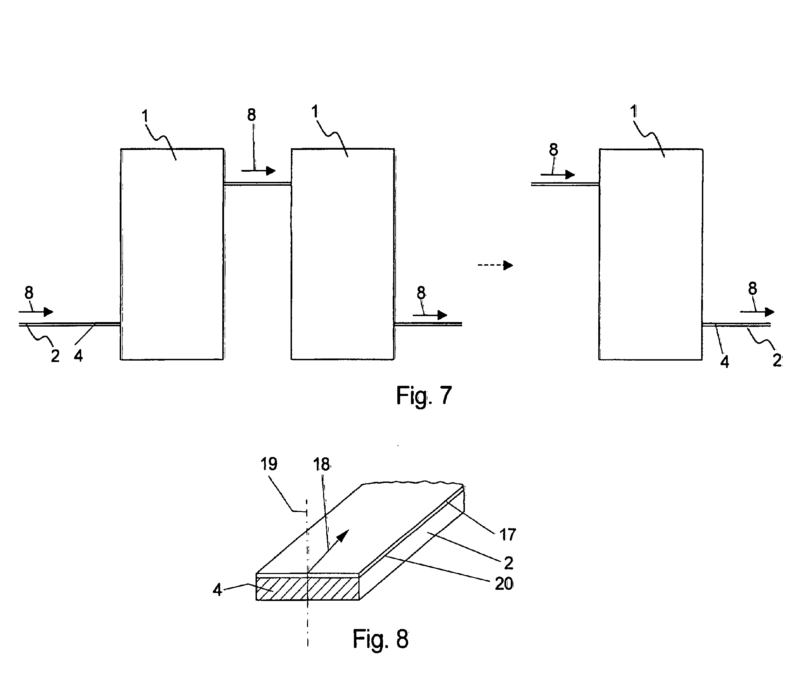

Um eine noch weitere Erhöhung der Schichtdicke der auf das Band 4 aufgebrachten Dünnschicht zu erreichen, ohne die Schichtdicke in jedem einzelnen Schritt, der jeweils von einer Kombination aus einer Quelle 9 und einer Quelle 10 ausgeführt wird, zu erhöhen, können mehrere Vorrichtungen 1 gemäß Fig. 5 oder Fig. 6 hintereinander geschaltet werden, wie dies in **Fig. 7** angedeutet ist. Dabei sollten sich alle Vorrichtungen 1 gemeinsam in einer Vakuumapparatur befinden oder aber Druckschleusen zwischen den einzelnen Vorrichtungen vorgesehen sein, so dass zumindest jede der Vorrichtungen 1 unter einer definierten Atmosphäre mit reduziertem Absolutdruck arbeiten kann.

**Fig. 8** zeigt in stark vergrößerter und nicht maßstabsgerechter Darstellung einen Querschnitt durch das Substrat 2 in Form des Bands 4, nachdem mit einer Vorrichtung 1 gemäß einer der Fig. 1 bis 6 eine Dünnschicht 17 aufgebracht wurde. Diese Dünnschicht 17 weist eine definierte biaxiale Kristallorientierung in Bezug auf die Längserstreckungsrichtung 18 des Bands 4 und die Oberflächennormale 19 zu der mit der Dünnschicht 17 beschichteten Oberfläche 20 des Substrats 2 auf. Diese biaxiale Orientierung resultiert bei der Röntgenanalyse der Textur der Dünnschicht 17 (phi-Scan) in Peaks begrenzter Halbwertsbreite von typischerweise ≤ 20°.

Die Erfindung wird im Folgenden anhand einiger Beispiele für das neue Verfahren zur Herstellung einer Dünnschicht und entsprechender Vergleichsbeispiele, die sich an der bekannten IBAD-Technik orientieren, noch weiter erläutert und beschrieben.

### Beispiel 1

Gemäß der vorliegenden Erfindung wurde eine texturierte Dünnschicht 17 aus mit Yttriumoxyd stabilisiertem Zirkonoxyd (YSZ) auf einem Band 4 aus rostfreiem CrNi-Stahl abgelagert. Das Band 4 aus rostfreiem Stahl war 10 m lang, 4 mm breit und 0,1 mm dick. Die Oberfläche 20 dieses Substrats 2 wurde elektrochemisch poliert, um die Oberflächenrauhigkeit auf 4 nm zu begrenzen. Das Band 4 wurde um die Trommel 13 der Vorrichtung 1 gemäß den Fig. 3 und 4 gewickelt, die dann in einer Vakuumkammer (in den Figuren 3 und 4 nicht gezeigt) positioniert wurde. In der Vakuumkammer war als Quelle 9 für Atome eine lonensputterquelle und als Quelle 10 für einen energetisierten Strahl eine lonenstrahlquelle vorgesehen. Der Durchmesser der Trommel 13 betrug 1 m. Die lonenstrahlquelle stellte einen lonenstrom aus Argonionen unter einem Einfallswinkel von 51° bis 58° zu dem Band 4 bereit. Die lonenstrahlquelle war eine lonenkanone vom Kaufmann-Typ mit 11 cm Durchmesser, die Teilchen mit einer Energie von 300 eV ± 20 eV lieferte. Die Quelle 10 stellte zusätzlich eine Neutralisierung der lonenladung sicher, indem sie gleichzeitig einen Elektronenstrom lieferte. Der Gesamtionenstrom entsprach etwa 100 mA. Der Einwirkungsbereich des energetisierten Strahls 12 an dem Umfang der Trommel 13 betrug etwa 120 mm x 80 mm. Die Quelle 9 für Atome lagerte Atome über einen Bereich von 80 mm x 80 mm am Umfang der Trommel 13 ab. Während der Ablagerung der Dünnschicht 17 drehte sich die Trommel 13 mit einer Frequenz von 1 min⁻¹ um ihre Drehachse 14. Die evakuierte Vakuumkammer enthielt Sauerstoff mit einem Partialdruck von 2x10⁻⁴ mbar, um reaktive Ablagerungsbindungen einzustellen. Aufgrund der Drehung der Trommel 13 wurde eine Abfolge von Schritten des Ablagerns und des Beaufschlagens mit dem energetisierten Strahl erzielt. Bei der Ablagerung der Dünnschicht 17 auf dem Band 4 stieg die Temperatur des Bands 4 an, aber nicht über 100 °C. Nach einer Versuchsdauer von 4,0 h war eine 460 nm dicke texturierte Dünnschicht aufgetragen, deren biaxiale Kristallorientierung sich bei der Röntgenanalyse der Textur in einer Halbwertsbreite (phi-Scan) von 18° widerspiegelte. Die Schichtdicke der Dünnschicht 17 von 460 nm entspricht bei insgesamt 240 Umdrehungen der Trommel 13 während der Versuchsdauer einer Schichtdicke pro Schritt des Ablagerns von Atomen und des zugehörigen Schritts des Beaufschlagens der abgelagerten Atome mit einem energetisierten Strahl von knapp 2 nm.

### Beispiel 2 (Vergleichsbeispiel, nicht zu der beanspruchten Erfindung gehörig)

Zum Zwecke des Vergleichs wurde eine texturierte Schicht aus mit Yttriumoxyd stabilisiertem Zirkonoxyd (YSZ) gemäß dem Stand der Technik nach der US 5,432,151 A ausgebildet, d. h. durch IBAD. Die Bedingungen dieses Beispiels waren dieselben wie beim Beispiel 1, außer dass die Einwirkungsbereiche der beiden Quellen 9 und 10 auf das Band 4 einander überlagert wurden, d. h. die Quelle 10 wurde gegenüber Fig. 3 zu der Quelle 9 hin um die Drehachse 14 um 180° verdreht. Weiterhin wurde der Bereich der Einwirkung des energetisierten Strahls 12 auf das Band 14 in seiner Größe an den Bereich der Einwirkung der Quelle 9 auf das Band 14 angepasst, so dass beide Bereiche 80 mm x 80 mm groß waren. Nach einer Versuchszeit von 3,9 h wurde eine 500 nm dicke texturierte Dünnschicht erhalten, deren biaxiale Kristallorientierung im Rahmen einer Röntgenanalyse durch eine Halbwertsbreite (phi-Scan) von 25° beschrieben wurde. D. h., die Textur war deutlich weniger ausgeprägt als in dem entsprechenden Beispiel 1 zu der vorliegenden Erfindung, obwohl die Dünnschicht 7, die in dem Beispiel 2 erzeugt wurde, sogar eine etwas höhere Schichtdicke aufwies als diejenige nach etwas längerer Versuchsdauer in dem Beispiel 1. Die in beiden Beispielen erzielten Produktionsraten waren aufgrund der nahezu identischen Versuchsdauern ebenfalls nahezu identisch, so dass die in dem Beispiel 1 erreichte deutlichere biaxiale Kristallorientierung entscheidend ist.

### Beispiel 3

Beispiel 3, das gemäß der vorliegenden Erfindung durchgeführt wurde, wurde unter denselben Bedingungen wie Beispiel 1 durchgeführt, außer dass die Versuchszeit auf 7,4 h erhöht wurde. Die erhaltende texturierte Dünnschicht hatte eine Schichtdicke von 850 nm, und ihre biaxiale Kristallorientierung zeigte bei der Röntgenanalyse eine Halbwertsbreite (phi-Scan) von 14°.

### Beispiel 4 (Vergleichsbeispiel, nicht zu der vorliegenden Erfindung gehörig)

Beispiel 4 wurde wieder gemäß IBAD unter den Bedingungen des Beispiels 2 durchgeführt, jedoch mit einer Versuchsdauer von 7,2 h und Abmessungen von 120 mm x 120 mm sowohl für den Einwirkungsbereich der Quelle 9 für Atome auf das Band 4 als auch den Einwirkungsbereich der Quelle 10 für einen energetisierten Strahl 12 auf das Band 4. Die abgelagerte Dünnschicht war 800 nm dick und zeigte bei der Röntgenanalyse eine Halbwertsbreite (phi-Scan) von 18°, d. h. eine deutlich weniger ausgeprägte biaxiale Kristallorientierung als die Dünnschicht nach Beispiel 3. Die Produktionsraten waren sowohl auf die Länge des Bandes als auch auf das Volumen der Dünnschicht bezogen in beiden Beispielen 3 und 4 etwa gleich groß. Bezogen auf das Volumen der Dünnschicht 17 war die Produktionsrate des Beispiels 3 sogar minimal größer.

### Beispiel 5

Beispiel 5 wurde gemäß der vorliegenden Erfindung unter denselben Bedingungen wie Beispiel 1 durchgeführt, außer dass die Versuchsdauer auf 11,3 h erhöht wurde. Die erhaltene texturierte Dünnschicht war 1250 nm dick und wies in der Röntgenanalyse eine Halbwertsbreite (phi-Scan) der Peaks von 12,2° auf. Auch dies ist verglichen mit der Schichtdicke der texturierten Schicht und auch der Produktionsgeschwindigkeit ein exzellenter Wert der biaxialen Kristallorientierung.

In der nachstehenden Tabelle sind die Ergebnisse der erfindungsgemäßen Beispiele 1, 3 und 5 den Vergleichsbeispielen 2 und 4 gegenübergestellt. Die Tabelle macht dabei noch einmal deutlich, dass mit dem erfindungsgemäßen Verfahren Dünnschichten höherer Qualität in Bezug auf die biaxiale Kristallorientierung erhalten werden. Die Tabelle lässt anhand der Ergebnisse der Beispiele 1 und 4 auch deutlich werden, dass es die vorliegende Erfindung erlaubt, die Produktionsgeschwindigkeit beim Erreichen einer biaxialen Kristallorientierung mit einer Halbwertsbreite von 18° um einen Faktor von 1,8 zu steigern (Quotient der Versuchsdauern der Beispiele 4 und 1 von 7,2 h und 4,0 h).

**Tabelle**

| Beispiel | Charakterisierung | Dicke der Dünnschicht [nm] | Textur Halbwertsbreite (phi-Scan) | Versuchsdauer [h] |
|---|---|---|---|---|
| 1 | erfindungsgemäß | 460 | 18° | 4.0 |
| 2 | Vergleichsbeispiel: IBAD | 500 | 25° | 3.9 |
| 3 | erfindungsgemäß | 850 | 14° | 7.4 |
| 4 | Vergleichsbeispiel: IBAD | 800 | 18° | 7.2 |
| 5 | erfindungsgemäß | 1250 | 12.2° | 11.3 |

### BEZUGSZEICHENLISTE

| | | | |
|---|---|---|---|
| 1 | Vorrichtung | 11 | Pfeil |
| 2 | Substrat | 12 | Strahl |
| 3 | Antrieb | 13 | Trommel |
| 4 | Band | 14 | Drehachse |
| 5 | Walze | 15 | Drehpfeil |
| 6 | Drehachse | 16 | Doppelpfeil |
| 7 | Drehpfeil | 17 | Dünnschicht |
| 8 | Pfeil | 18 | Haupterstreckungsrichtung |
| 9 | Quelle für Atome | 19 | Oberflächennormale |
| 10 | Quelle für einen energetisierten Strahl | 20 | Oberfläche |
| | | | |
| A | Bereich | α | Winkel |
| B | Bereich | | |

## Patentansprüche

1. Verfahren zur Herstellung von Dünnschichten, die eine biaxiale Kristallorientierung aufweisen, mit den Schritten:
- Ablagern von Atomen in einer der gewünschten Dünnschicht entsprechenden Zusammensetzung auf einem Substrat und,
- zeitlich getrennt von dem Schritt des Ablagerns von Atomen, Beaufschlagen der abgelagerten Atome mit einem energetisierten Strahl, der unter einem Winkel aus einem vorgegebenen Winkelbereich zu dem Substrat ausgerichtet ist,
wobei die Schritte des Ablagems von Atomen auf dem Substrat (2) und des Beaufschlagens der abgelagerten Atome mit einem energetisierten Strahl (12) mehrfach alternierend wiederholt werden,
**dadurch gekennzeichnet, dass** in jedem Schritt des Ablagems von Atomen auf dem Substrat (2) nicht zusammenhängende Cluster von Atomen auf dem Substrat bzw. den bereits zuvor mit einem energetisierten Strahl (12) beaufschlagten Atomen abgelagert werden.

2. Verfahren nach Anspruch 1, d**adurch gekennzeichnet, dass** in jedem Schritt des Beaufschlagens der abgelagerten Atome mit einem energetisierten Strahl (12) Cluster von zuvor abgelagerten Atomen entfernt werden, die nicht die biaxiale Kristallorientierung aufweisen.

3. Verfahren nach einem der Ansprüche 1 und 2, **dadurch gekennzeichnet, dass** das Substrat (2) auf einer Kreis- oder Spiralbahn kontinuierlich umlaufend mehrfach wiederholt durch getrennte räumliche Bereiche (A, B) geführt wird, in denen die Schritte des Ablagerns von Atomen auf dem Substrat (2) einerseits und des Beaufschlagens der abgelagerten Atome mit einem energetisierten Strahl (12) andererseits erfolgen.

4. Verfahren nach Anspruch 3, **dadurch gekennzeichnet, dass** das Substrat (2) in jedem Bereich (B), in dem ein Schritt des Beaufschlägens der abgelagerten Atome mit einem energetisierten Strahl (12) erfolgt, in einer Ebene ausgerichtet ist.

## Claims

1. Process of manufacturing thin layers having a biaxial crystal orientation, the method comprising the steps of:
- depositing atoms of a composition corresponding to the desired thin layer on a substrate, and
- temporally separated from the step of depositing atoms, subjecting the deposited atoms with an energized beam which is oriented at an angle of a predetermined range of angles with regard to the substrate,
wherein the steps of depositing atoms on the substrate (2) and of subjecting the deposited atoms to the energized beam (12) are alternatively repeated several times, **characterized in that** in each step of depositing atoms on the substrate (2) clusters of atoms, which are not interconnected, are deposited on the substrate or the atoms already previously subjected to an energized beam (12).

2. Method of claim 1, **characterized in that** in each step of subjecting the deposited atoms with an energized beam (12), clusters of previously deposited atoms are removed, which do not have the biaxial crystal orientation.

3. Method of any of the claims 1 and 2, **characterized in that** the substrate (2) is guided continuously circulating on a circular or spiral path through separated spatial areas (A, B) in which the steps of depositing atoms on the substrate (2) on the one hand and of subjecting the deposited atoms to an energized beam (12) on the other hand take place.

4. Method of claim 3, **characterized in that** the substrate (2) is oriented within one plane in each area (B) in which a step of subjecting the deposited atoms to the energized beam (12) takes place.

## Revendications

1. Procédé de réalisation de couches minces, qui ont une orientation biaxiale des monocristaux, comportant les étapes :
- dépôt d'atomes sur un substrat selon une composition correspond à la couche mince souhaitée, et
- à un moment séparé de l'étape du dépôt des atomes, excitation des atomes déposés avec un rayon énergisé, qui est dirigé vers le substrat en formant un angle, choisi dans une plage angulaire prédéfinie,
les étapes du dépôt des atomes sur le substrat (2) et de l'excitation des atomes déposés avec un rayon énergisé (12) étant répétées plusieurs fois en alternance, **caractérisé en ce que**, dans chaque étape de dépôt des atomes sur le substrat (2), des amas d'atomes non contigus sont déposés sur le substrat ou sur les atomes déjà excités préalablement par un rayon énergisé (12).

2. Procédé selon la revendication 1, **caractérisé en ce que**, dans chaque étape d'excitation des atomes déposés avec un rayon énergisé (12), des amas d'atomes déposés préalablement et n'ayant pas l'orientation biaxiale des monocristaux sont enlevés.

3. Procédé selon les revendications 1 et 2, **caractérisé en ce que** le substrat (2) est guidé à plusieurs reprises en continu de manière rotative sur une trajectoire circulaire ou en spirale à travers des zones (A, B) séparées dans l'espace, dans lesquelles sont mises en oeuvre les étapes du dépôt des atomes sur le substrat (2), d'une part, et l'excitation des atomes déposés avec un rayon énergisé (12), d'autre part.

4. Procédé selon la revendication 3, **caractérisé en ce que** le substrat (2) est orienté dans un plan dans chaque zone (B), dans laquelle est mise en oeuvre une étape d'excitation des atomes déposés avec un rayon énergisé (12).
